# EUROPÄISCHE PATENTSCHRIFT

(11) **EP 2 534 661 B1**
(45) Veröffentlichungstag und Bekanntmachung des Hinweises auf die Patenterteilung: **03.05.2017**
(21) Anmeldenummer: 11702271.5
(22) Anmeldetag: 09.02.2011
(51) Int. Cl.: H01C 7/10, H01C 7/12, H01G 4/40, H03H 7/01, H03H 1/00

(54) **KERAMISCHES VIELSCHICHTBAUELEMENT**
CERAMIC MULTILAYER COMPONENT
COMPOSANT MULTICOUCHE CÉRAMIQUE

(30) Priorität: 10.02.2010 DE 102010007443
(43) Veröffentlichungstag der Anmeldung: 19.12.2012
(73) Patentinhaber: Epcos AG, 81669 München (DE)
(72) Erfinder: FEICHTINGER, Thomas, A-8010 Graz (AT); DOTTA, Pascal, A-8063 Eggersdorf b. Graz (AT); SCHIECHL, Hannes, A-8043 Graz (AT)
(74) Vertreter: Epping - Hermann - Fischer
(86) Internationale Anmeldenummer: PCT/EP2011/051901
(87) Internationale Veröffentlichungsnummer: WO 2011/098489

(56) Entgegenhaltungen:
- WO-A1-2010/012661
- JP-A- 2002 222 712

## Beschreibung

Aus der Druckschrift DE 10 2005 025 680 A1 ist ein Vielschichtbauelement mit einem Varistor und einem LC-Filter bekannt.

DE 10 2008 019 127 A1 beschreibt ein Vielschichtbauelement mit einer Ferritkeramik, die Elektrodenstrukturen aufweist, die eine Induktivität bilden. Das Vielschichtbauelement besitzt außerdem einen kapazitiven Bereich, der eine Varistorkeramik umfasst.

WO 2010/012661 A1 beschreibt ein Vielschichtbauelement, das wenigstens einen induktiven Bereich mit einer Ferritkeramik und wenigstens einen kapazitiven Bereich aufweist. Auf der äußeren Oberseite des induktiven Bereichs befindet sich eine Spulenstruktur, die die Induktivität bildet.

JP 2002 222712 A beschreibt ein Vielschichtbauelement, bei dem eine Induktivität durch eine zwischen Ferritschichten angeordnete ebene Spulenstruktur gebildet ist.

Aufgabe der vorliegenden Erfindung ist es, ein keramisches Vielschichtbauelement für eine Integration einer Induktivität und einer ESD-Schutzfunktion anzugeben.

Diese Aufgabe wird durch das Vielschichtbauelement mit den Merkmalen des Anspruches 1 gelöst. Ausgestaltungen ergeben sich aus den abhängigen Ansprüchen.

Das keramische Vielschichtbauelement weist einen Grundkörper mit daran angebrachten Anschlusskontakten, eine für einen induktiven Bereich in dem Grundkörper vorgesehene Ferritkeramik, in der eine durch elektrische Leiter gebildete Induktivität angeordnet ist, sowie eine Varistorkeramik in dem Grundkörper auf, wobei die Varistorkeramik höchstens 40% des Volumens des Grundkörpers umfasst. Die Varistorkeramik bildet mit den Anschlusskontakten eine Kapazität.

Bei einem Ausführungsbeispiel ist die Varistorkeramik an einer Außenseite des Grundkörpers angeordnet.

Bei einem weiteren Ausführungsbeispiel ist die Varistorkeramik eine Schichtlage eines Oberflächenvaristors, und der Oberflächenvaristor umfasst höchstens 20% des Volumens des Grundkörpers.

Bei einem weiteren Ausführungsbeispiel ist eine metallische oder oxidische Zwischenschicht zwischen der Ferritkeramik und der Varistorkeramik angeordnet. Die Zwischenschicht kann als Diffusionssperre vorgesehen sein, um eine Diffusion von Dotierstoffen zu unterbinden. Ohne eine Zwischenschicht könnten beispielsweise Dotierstoffe aus der Varistorkeramik in die Ferritkeramik diffundieren oder Dotierstoffe aus der Ferritkeramik in die Varistorkeramik.

Bei einem weiteren Ausführungsbeispiel ist die Varistorkeramik für eine ESD-Schutzfunktion vorgesehen.

Bei einem weiteren Ausführungsbeispiel bilden die Kapazität und die Induktivität ein LC-Filter.

Die Ferritkeramik kann zum Beispiel ein NiZn-Ferrit, NiCuZn-Ferrit, NiZnCo-Ferrit, NiCuZnCo-Ferrit oder hexagonales Ferrit umfassen. Die Varistorkeramik kann zum Beispiel eine ZnO-Bi-Sb-Keramik oder eine ZnO-Pr-Keramik umfassen.

Die Anschlusskontakte können insbesondere zum Beispiel als Ball-Grid-Array oder als Land-Grid-Array vorgesehen sein.

Die Anordnung von kapazitiven und induktiven Bereichen im Aufbau des Vielschichtbauelementes ist vorzugsweise symmetrisch in Bezug auf eine Schichtebene. Ein symmetrischer Aufbau weist insbesondere Vorteile hinsichtlich der Charakteristik des Filters auf und besitzt außerdem Vorteile für die Herstellung.

Die Varistorkeramik besitzt eine hohe relative Dielektrizitätszahl (auch als Dielektrizitätskonstante bezeichnet), so dass hohe Kapazitäten erreicht werden. Mit der Verwendung einer Ferritkeramik können sehr hohe Induktivitätswerte erreicht werden, da Ferritkeramiken eine vergleichsweise hohe Permeabilität, typisch zwischen 1 und 50 aufweisen. Eine Ferritkeramik mit niedriger relativer Dielektrizitätszahl verringert unerwünschte kapazitive Kopplungen. Wenn der Varistor an einer Außenseite des Bauelementes angeordnet ist, steht das Volumen des Bauelementes vorwiegend für den Aufbau der Induktivität zur Verfügung, so dass trotz kompakter Abmessungen höhere Induktivitäten realisiert werden können als mit herkömmlichen Bauelementen vergleichbarer Funktion.

Die Kombination aus Varistorkeramik und Ferritkeramik ermöglicht es, eine Vielzahl unterschiedlicher LC-Filter-Designs zu realisieren. Auch können die Filterfunktion und eine ESD-Schutzfunktion in einem Bauteil integriert werden. Dabei wird die ESD-Schutzfunktion durch die Verwendung einer Varistorkeramik und die Filterfunktion durch die Verwendung einer Ferritkeramik realisiert. Es ist insbesondere möglich, mehrere LC-Filter in einem Bauelement als Array anzuordnen. Dazu werden mehrere LC-Filter beispielsweise nebeneinander in einem gemeinsamen Bauelement angeordnet.

Es folgt eine genauere Beschreibung von Beispielen des Vielschichtbauelementes anhand der beigefügten Figuren.
Die Figur 1 zeigt einen schematischen Querschnitt eines Ausführungsbeispiels des Vielschichtbauelementes.
Die Figur 2 zeigt eine Seitenansicht eines Ausführungsbeispiels mit Oberflächenvaristor.
Die Figur 3 zeigt eine Draufsicht auf das Ausführungsbeispiel der Figur 2.
Die Figur 4 zeigt eine Seitenansicht eines Ausführungsbeispiels ohne Zwischenschicht.
Die Figur 5 zeigt eine Seitenansicht eines weiteren Ausführungsbeispiels mit Oberflächenvaristor.
Die Figur 6 zeigt eine Seitenansicht eines weiteren Ausführungsbeispiels mit Oberflächenvaristor.
Die Figur 7 zeigt einen schematischen Querschnitt eines weiteren Ausführungsbeispiels.
Die Figur 8 zeigt eine Seitenansicht eines weiteren Ausführungsbeispiels mit Ball-Grid-Array.
Die Figur 9 zeigt einen schematischen Querschnitt eines weiteren Ausführungsbeispiels.

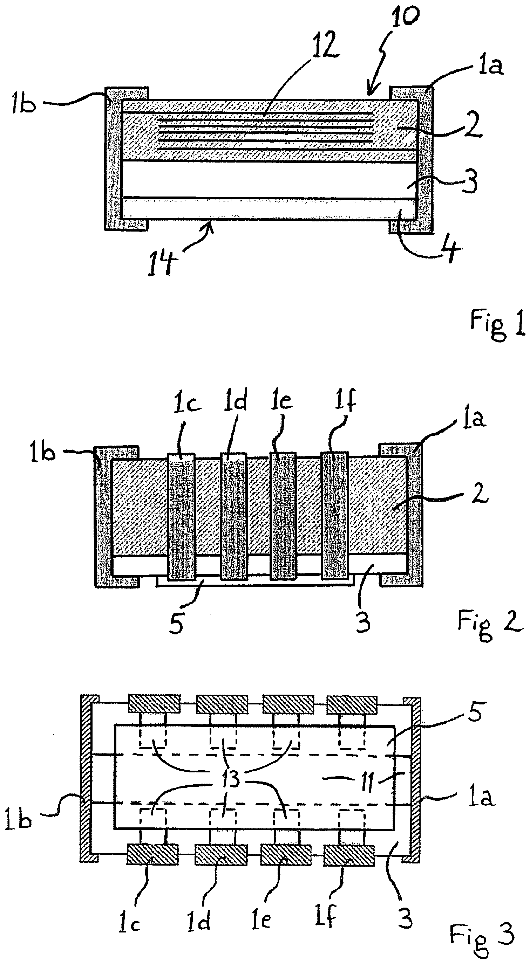

In Figur 1 ist ein schematischer Querschnitt eines Ausführungsbeispiels des Vielschichtbauelementes gezeigt. Das Vielschichtbauelement umfasst einen induktiven Bereich und einen kapazitiven Bereich in einem Grundkörper 10. Der induktive Bereich befindet sich in einer Ferritkeramik 2, die Leiterstrukturen enthält, die eine Induktivität 12 bilden.

Die Induktivität 12 kann typisch durch eine spulenartig gewundene Leiterstruktur gebildet sein. Der kapazitive Bereich befindet sich in einer Varistorkeramik 4, die höchstens 40% des Volumens des Grundkörpers 10 umfasst und vorzugsweise an einer Außenseite 14 des Grundkörpers 10 angeordnet ist. Der kapazitive Bereich umfasst eine ebenfalls durch Leiterstrukturen gebildete Kapazität und kann einen ohmschen Widerstand aufweisen. Diese Leiterstrukturen können insbesondere Elektrodenstapel umfassen. Die Induktivität und die Kapazität können insbesondere einen LC-Filter bilden. Das Vielschichtbauelement ist zum Anschluss der Leiterstrukturen nach außen mit Anschlusskontakten 1a, 1b versehen. Die Anschlusskontakte 1a, 1b sind zum Beispiel, wie in der Figur 1 dargestellt, auf Endflächen des Grundkörpers 10 angeordnet. Zwischen der Ferritkeramik 2 und der Varistorkeramik 4 kann eine Zwischenschicht 3, zum Beispiel aus einem Dielektrikum, angeordnet sein. Die Zwischenschicht 3 kann insbesondere Oxid sein. Hierfür sind zum Beispiel Oxide von Magnesium, Zirkon oder Titan geeignet, von denen auch eine Mischung in der Zwischenschicht 3 verwendet werden kann. Die Zwischenschicht 3 kann statt dessen eine metallische Zwischenschicht sein.

Die Figur 2 zeigt eine Seitenansicht eines weiteren Ausführungsbeispiels. Bei diesem Ausführungsbeispiel weist der Grundkörper einen Oberflächenvaristor 5 aus einer Varistorkeramik auf. Die Ferritkeramik 2 umfasst einen deutlich größeren Anteil des Grundkörpers als bei dem Ausführungsbeispiel der Figur 1, und der Oberflächenvaristor 5 nimmt höchstens 20% des Volumens des Grundkörpers ein. Zwischen der Ferritkeramik 2 und dem Oberflächenvaristor 5 kann wie bei dem Ausführungsbeispiel der Figur 1 eine Zwischenschicht 3 vorgesehen werden. Die Zwischenschicht 3 kann statt dessen weggelassen sein. Für den elektrischen Anschluss sind zusätzlich zu den auf den Endflächen des Grundkörpers vorgesehenen Anschlusskontakten 1a, 1b mehrere parallel zueinander angeordnete streifenförmige Anschlusskontakte 1c, 1d, 1e, 1f auf den Seitenflächen vorhanden.

Die Figur 3 zeigt eine Draufsicht auf die mit dem Oberflächenvaristor 5 versehene Seite des Ausführungsbeispiels der Figur 2. In der Figur 3 sind die Positionen der externen elektrischen Anschlüsse erkennbar. Von den Anschlusskontakten 1a, 1b, 1c, 1d, 1e, 1f gehen Anschlussleiter 11, 13 zu dem Oberflächenvaristor 5.

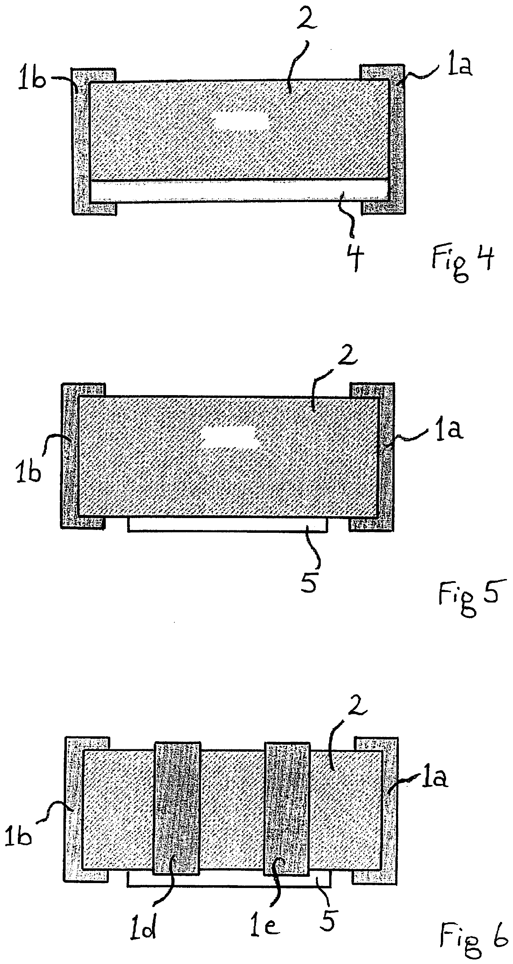

Die Figur 4 zeigt eine Seitenansicht eines weiteren Ausführungsbeispiels, bei dem die Zwischenschicht 3 weggelassen ist und die Ferritkeramik 2 und die Varistorkeramik 4 aneinander angrenzend angeordnet sind. Die Varistorkeramik 4 nimmt bei diesem Ausführungsbeispiel nur höchstens 20% des Volumens des Grundkörpers ein. Auf diese Weise steht ein großes Volumen des Bauelementes für eine entsprechend große Induktivität zur Verfügung.

Die Figur 5 zeigt eine Seitenansicht eines weiteren Ausführungsbeispiels, bei dem ein Oberflächenvaristor 5 an einer Außenseite des Grundkörpers auf der Ferritkeramik 2 angeordnet ist. Der Grundkörper besteht fast nur aus der Ferritkeramik 2. Auf diese Weise steht ein noch größeres Volumen des Bauelementes als bei dem Ausführungsbeispiel der Figur 4 für eine besonders große Induktivität zur Verfügung.

Die Figur 6 zeigt eine Seitenansicht eines weiteren Ausführungsbeispiels, bei dem wie bei dem Ausführungsbeispiel der Figur 5 ein Oberflächenvaristor 5 an einer Außenseite des Grundkörpers auf der Ferritkeramik 2 angeordnet ist und der Grundkörper fast nur aus der Ferritkeramik 2 besteht. Für den elektrischen Anschluss sind zusätzlich zu den auf den Endflächen des Grundkörpers angeordneten Anschlusskontakten 1a, 1b auf den Seitenflächen parallel zueinander angeordnete streifenförmige Anschlusskontakte 1d, 1e vorhanden.

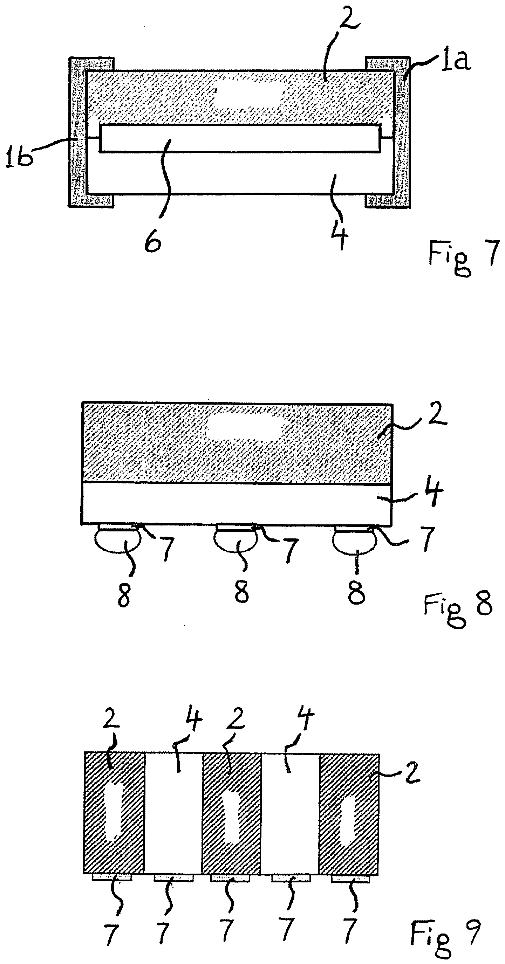

In der Figur 7 ist ein weiteres Ausführungsbeispiel des Vielschichtbauelementes mit einem ähnlichen Aufbau wie bei dem Ausführungsbeispiel der Figur 1 dargestellt. Zwischen der Ferritkeramik 2 mit dem induktiven Bereich und der Varistorkeramik 4 mit dem kapazitiven Bereich befindet sich eine metallhaltige Bufferschicht 6. Die Bufferschicht 6 dient als Diffusionssperre zwischen der Ferritkeramik 2 und der Varistorkeramik 4.

Die Figur 8 zeigt ein Ausführungsbeispiel, bei dem die externen elektrischen Anschlüsse durch ein Ball-Grid-Array gebildet sind. Auf der Varistorkeramik 4 sind Anschlusskontakte 7 angeordnet, die jeweils mit einem Ball-Grid-Array-Kontakt 8 versehen sind.

Die Figur 9 zeigt ein Ausführungsbeispiel, bei dem die externen elektrischen Anschlüsse durch ein Land-Grid-Array gebildet sind. In einer Längsrichtung des Grundkörpers sind mehrere Bereiche aus Ferritkeramik 2 und Varistorkeramik 4 im Wechsel vertikal angeordnet. Auf diesen Bereichen sind jeweils Anschlusskontakte 7 vorhanden. Auch bei diesem Ausführungsbeispiel umfasst die Varistorkeramik 4 höchstens 40% des Volumens des Grundkörpers, so dass ein großes Volumen des Bauelementes für die Induktivität in der Ferritkeramik zur Verfügung steht.

Die beschriebenen Ausführungsbeispiele des keramischen Vielschichtbauelementes lassen sich in einer Vielzahl von Schaltungen einsetzen. In einem LC-Filter mit einer Induktivität in einer ersten Leitung und einer Kapazität zwischen der ersten Leitung und einer dazu parallelen zweiten Leitung können zum Beispiel Varistoren eingangsseitig und ausgangsseitig zwischen die Leitungen geschaltet sein. Die Varistoren dienen als ESD-Schutzelemente für das LC-Filter. Das LC-Filter kann als Pi-Typ-LC-Filter ausgebildet sein, wobei eingangsseitig und ausgangsseitig je eine Kapazität zwischen der ersten Leitung und der zweiten Leitung vorhanden ist. Weitere Ausführungsbeispiele können auf der Oberfläche des Vielschichtbauelementes Widerstände oder andere elektronische Bauelemente aufweisen, die mit dem LC-Filter verschaltet sind. Auf diese Weise können insbesondere RLC-Filter gebildet werden, bei denen die Induktivität und ein Widerstand in Reihe geschaltet sind. Auch hierbei dienen Varistoren als ESD-Schutzelemente.

### Bezugszeichenliste

- 1a: Anschlusskontakt
- 1b: Anschlusskontakt
- 1c: Anschlusskontakt
- 1d: Anschlusskontakt
- 1e: Anschlusskontakt
- 1f: Anschlusskontakt
- 2: Ferritkeramik
- 3: Zwischenschicht
- 4: Varistorkeramik
- 5: Oberflächenvaristor
- 6: Bufferschicht
- 7: Anschlusskontakt
- 8: Ball-Grid-Array-Kontakt
- 10: Grundkörper
- 11: Anschlussleiter
- 12: Induktivität
- 13: Anschlussleiter
- 14: Außenseite

## Patentansprüche

1. Keramisches Vielschichtbauelement mit
- einem Grundkörper (10) mit daran angebrachten Anschlusskontakten (1a, 1b, 1c, 1d, 1e, 1f; 7),
- einer für einen induktiven Bereich in dem Grundkörper (10) vorgesehenen Ferritkeramik (2), in der eine durch elektrische Leiter gebildete Induktivität (12) angeordnet ist, und
- einer Varistorkeramik (4) in dem Grundkörper (10),
**dadurch gekennzeichnet, dass**
- die Varistorkeramik (4) höchstens 40% des Volumens des Grundkörpers (10) umfasst und
- die Varistorkeramik (4) mit den Anschlusskontakten (1a, 1b, 1c, 1d, 1e, 1f; 7) eine Kapazität bildet.

2. Vielschichtbauelement nach Anspruch 1, bei dem
die Varistorkeramik (4) an einer Außenseite (14) des Grundkörpers (10) angeordnet ist.

3. Vielschichtbauelement nach Anspruch 1 oder 2, bei dem
die Varistorkeramik (4) eine Schichtlage eines Oberflächenvaristors (5) bildet und der Oberflächenvaristor höchstens 20% des Volumens des Grundkörpers (10) umfasst.

4. Vielschichtbauelement nach einem der Ansprüche 1 bis 3, bei dem
eine metallische oder oxidische Zwischenschicht (3) zwischen der Ferritkeramik (2) und der Varistorkeramik (4) angeordnet ist.

5. Vielschichtbauelement nach einem der Ansprüche 1 bis 4, bei dem
die Varistorkeramik (4) für eine ESD-Schutzfunktion vorgesehen ist.

6. Vielschichtbauelement nach einem der Ansprüche 1 bis 5, bei dem
die Induktivität (12) und die Kapazität ein LC-Filter bilden.

7. Vielschichtbauelement nach einem der Ansprüche 1 bis 6, bei dem
die Ferritkeramik (2) ein NiZn-Ferrit, NiCuZn-Ferrit, NiZnCo-Ferrit, NiCuZnCo-Ferrit oder hexagonales Ferrit umfasst.

8. Vielschichtbauelement nach einem der Ansprüche 1 bis 7, bei dem
die Varistorkeramik (4) eine ZnO-Bi-Sb-Keramik oder eine ZnO-Pr-Keramik umfasst.

9. Vielschichtbauelement nach einem der Ansprüche 1 bis 8, bei dem
die Anschlusskontakte (7) für ein Ball-Grid-Array oder ein Land-Grid-Array vorgesehen sind.

## Claims

1. Ceramic multilayer component having
- a base body (10) with connecting contacts (la, 1b, 1c, 1d, 1e, 1f; 7), fitted to it,
- a ferrite ceramic (2), which is provided for an inductive area in the base body (10) and in which an inductance (12) is arranged which is formed by electrical conductors, and
- a varistor ceramic (4) in the base body (10),
**characterized in that**
- the varistor ceramic (4) comprises at most 40% of the volume of the base body (10) and
- the varistor ceramic (4) together with the connecting contacts (1a, 1b, 1c, 1d, 1e, 1f; 7) forms a capacitance.

2. Multilayer component according to Claim 1, in which
the varistor ceramic (4) is arranged on an outer face (14) of the base body (10).

3. Multilayer component according to Claim 1 or 2, in which
the varistor ceramic (4) forms a stratum layer of a surface varistor (5), and the surface varistor comprises at most 20% of the volume of the base body (10).

4. Multilayer component according to one of Claims 1 to 3,
in which
a metallic or oxidic intermediate layer (3) is arranged between the ferrite ceramic (2) and the varistor ceramic (4).

5. Multilayer component according to one of Claims 1 to 4,
in which
the varistor ceramic (4) is provided for an ESD protection function.

6. Multilayer component according to one of Claims 1 to 5,
in which
the inductance (12) and the capacitance form an LC filter.

7. Multilayer component according to one of Claims 1 to 6,
in which
the ferrite ceramic (2) comprises an NiZn ferrite, NiCuZn ferrite, NiZnCo ferrite, NiCuZnCo ferrite or hexagonal ferrite.

8. Multilayer component according to one of Claims 1 to 7,
in which
the varistor ceramic (4) comprises a ZnO-Bi-Sb ceramic or a ZnO-Pr ceramic.

9. Multilayer component according to one of Claims 1 to 8,
in which
the connecting contacts (7) are provided for a ball grid array or a land grid array.

## Revendications

1. Élément céramique multicouche présentant
- un corps de base (10) sur lequel sont appliqués des contacts de connexion (1a, 1b, 1c, 1d, 1e, 1f ; 7),
- une céramique de type ferrite (2) prévue pour une zone inductive dans le corps de base (10), dans laquelle est agencée une inductance (12) formée par des conducteurs électriques et
- une céramique de varistance (4) dans le corps de base (10), **caractérisé**
**en ce que**
- la céramique de varistance (4) constitue au plus 40% du volume du corps de base (10) et
- la céramique de varistance (4) forme une capacité avec les contacts de connexion (1a, 1b, 1c, 1d, 1e, 1f ; 7).

2. Élément multicouche selon la revendication 1, dans lequel la céramique de varistance (4) est disposée au niveau d'une face externe (14) du corps de base (10).

3. Élément multicouche selon la revendication 1 ou 2, dans lequel la céramique de varistance (4) forme une couche d'une varistance (5) de surface et la varistance de surface constitue au plus 20% du volume du corps de base (10).

4. Élément multicouche selon l'une quelconque des revendications 1 à 3, dans lequel une couche intermédiaire (3) métallique ou oxyde est disposée entre la céramique de type ferrite (2) et la céramique de varistance (4).

5. Élément multicouche selon l'une quelconque des revendications 1 à 4, dans lequel la céramique de varistance (4) est prévue pour une fonction de protection contre les décharges électrostatiques (ESD).

6. Élément multicouche selon l'une quelconque des revendications 1 à 5, dans lequel l'inductance (12) et la capacité forment un filtre LC.

7. Élément multicouche selon l'une quelconque des revendications 1 à 6, dans lequel la céramique de type ferrite (2) comprend une ferrite de NiZn, une ferrite de NiCuZn, une ferrite de NiZnCo, une ferrite de NiCuZnCo ou une ferrite hexagonale.

8. Élément multicouche selon l'une quelconque des revendications 1 à 7, dans lequel la céramique de varistance (4) comprend une céramique ZnO-Bi-Sb ou une céramique ZnO-Pr.

9. Élément multicouche selon l'une quelconque des revendications 1 à 8, dans lequel les contacts de connexion (7) sont prévus pour un boîtier matriciel à billes ou un boîtier matriciel à plots.
